**Europäisches Patentamt**

**European Patent Office**

**Office européen des brevets**

(19)

(11) Veröffentlichungsnummer: **0 151 718**
**A2**

(12) # EUROPÄISCHE PATENTANMELDUNG

(21) Anmeldenummer: 84114621.0

(22) Anmeldetag: 01.12.84

(51) Int. Cl.⁴: **H 01 L 33/00**

(30) Priorität: 08.12.83 SE 8306780

(43) Veröffentlichungstag der Anmeldung:
21.08.85 Patentblatt 85/34

(84) Benannte Vertragsstaaten:
DE FR GB NL

(71) Anmelder: ASEA AB

S-721 83 Västeras(SE)

(72) Erfinder: Hidman, Tomas, Dipl.-Ing.
Rotorvägen 4
S-722 24 Västeras(SE)

(72) Erfinder: Ovrén, Christer, Dr. techn.
Vilddjursvägen 9
S-722 43 Västeras(SE)

(74) Vertreter: Boecker, Joachim, Dr.-Ing.
Rathenauplatz 2-8
D-6000 Frankfurt a.M. 1(DE)

(54) **Halbleiterbauteil zur Erzeugung einer optischen Strahlung.**

(57) Ein Halbleiterbauteil zur Erzeugung einer optischen Strahlung, zum Beispeil eine Leuchtdiode, hat einen näher an der Außenfläche des Bauteils liegenden ersten Bereichs (26, 27) und einen an diesen Bereich angrenzenden, weiter von der genannten Außenfläche liegenden zweiten Bereich (25). Der erste Bereich hat einen zentralen Teil (26) mit einem Leitungstyp, der dem Leitungstyp des zweiten Bereiches entgegengesetzt ist, und der Übergang zwischen dem zentralen Bereich und dem zweiten Bereich ist der lichtemittierende aktive Teil des Halbleiterbauteils. Der erste Bereich hat ferner einen peripheren Bereich (27) von gleichem Leitungstyp wie der zweite Bereich. Dieser periphere Teil umschließt den zentralen Teil des ersten Bereiches. Das Material des ersten Bereiches hat einen größeren Bandabstand als das Material des zweiten Bereiches.

FIG. 1

27.11.1984
21 517 PE
0151718

ASEA AB
S-721 83 Västeras/Schweden

Halbleiterbauteil zur Erzeugung einer optischen Strahlung

Die vorliegende Erfindung betrifft ein Halbleiterbauteil zur Erzeugung einer optischen Strahlung gemäß dem Oberbegriff des Anspruches 1.

Leuchtdioden werden für die Umwandlung von elektrischer Energie in optische Energie (Licht) verwendet. Normale Betriebsströme liegen im Bereich von 10 bis 100 mA. Bei diesen Stromstärken ist der Wirkungsgrad der für solche Leuchtdioden verwendeten bekannten Halbleiterbauteile im allgemeinen groß. Für infrarotemittierende Strukturen beträgt der interne Quantenwirkungsgrad 80 - 90 % bei kommerziell erhältlichen Halbleiterbauteilen. Bei niedrigen Stromstärken durch die Diode, zum Beispiel bei 10 µA, sinkt die Quanteneffektivität sehr stark ab und liegt häufig nur im Promilleniveau. Dies liegt daran, daß bei diesen Stromstärken der Ladungsträgertransport durch das Bauteil im wesentlichen durch einen Strom erfolgt, der parallel zur Fläche des Halbleiterbauteils fließt, und der zur Lichtemission keinen Betrag leistet.

Es gibt jedoch viele Anwendungsgebiete, bei denen auch bei niedrigen Stromstärken ein hoher Wirkungsgrad des lichtemittierende Halbleiterbauteils erwünscht ist. Ein Beispiel hierfür sind faseroptische Meßsysteme, bei welchen die Speiseleistung für irgendeinen Meßwertumwandler nur durch optische Fasern zugeführt wird. Das Meßsignal solcher Meßwertumwandler wird durch das optische Fasersystem zurückgeleitet, beispielsweise mittels optischer Signale, die von einer Leuchtdiode erzeugt werden. Für die Speisung einer solchen Leuchtdiode steht nur eine begrenzte Leistung zur Verfügung, und die Gesamtleistung des Systems wird häufig von dem Wirkungsgrad der Leuchtdiode bestimmt. Ein solches Anwendungsbeispiel wird in der EP-Veröffentlichungsschrift 0041668 beschrieben.

Ein weiteres Beispiel für das Bedürfnis nach einem Halbleiterbauteil mit einer Leuchtdiode mit hohem Wirkungsgrad ist die zweirichtungsbetriebene optische Kommunikation durch optische Fasern, bei der der einen Station ausschließlich Versorgungsleistung über die optischen Fasern zugeführt wird. Ein solches System wird teilweise in der Schrift "The Bell System Technical Journal", Vol. 57, Nr. 11, November 1978, Seite 3309 beschrieben.

Der Erfindung liegt die Aufgabe zugrunde, ein Halbleiterbauteil der eingangs genannten Art zu entwickeln, bei welchem die lichtemittierenden Dioden bei kleinen Speiseströmen einen hohen Wirkungsgrad hinsichtlich der von ihnen erzeugten optischen Energie haben.

Zur Lösung dieser Aufgabe wird ein Halbleiterbauteil gemäß dem Oberbegriff des Anspruches 1 vorgeschlagen, welches erfindungsgemäß die im kennzeichnenden Teil des Anspruches 1 genannten Merkmale hat.

Vorteilhafte Ausgestaltungen der Erfindung sind in den weiteren Ansprüchen genannt.

Die Erfindung gründet sich darauf, daß der Bereich, in welchem der aktive Bereich des Halbleiterbauteils die Oberfläche des Halbleiterbauteils schneidet, einen größeren

27.11.1984
21 517 PE
0151718

Bandabstand hat als der Bereich, in welchem die Emittierung des Lichtes stattfindet.

Anhand der in den Figuren gezeigten Ausführungsbeispiele soll die Erfindung näher erläutert werden. Es zeigen

Figur 1 ein bekanntes Halbleiterbauteil der hier behandelten Art,

Figur 2 einen Schnitt durch die Schichten eines Ausführungsbeispiels eines Halbleiterbauteils nach der Erfindung,

Figur 3 das Halbleiterbauteil gemäß Figur 2 von unten gesehen,

Figur 4 ein zweites Ausführungsbeispiel nach der Erfindung in gleicher Darstellung wie Figur 2.

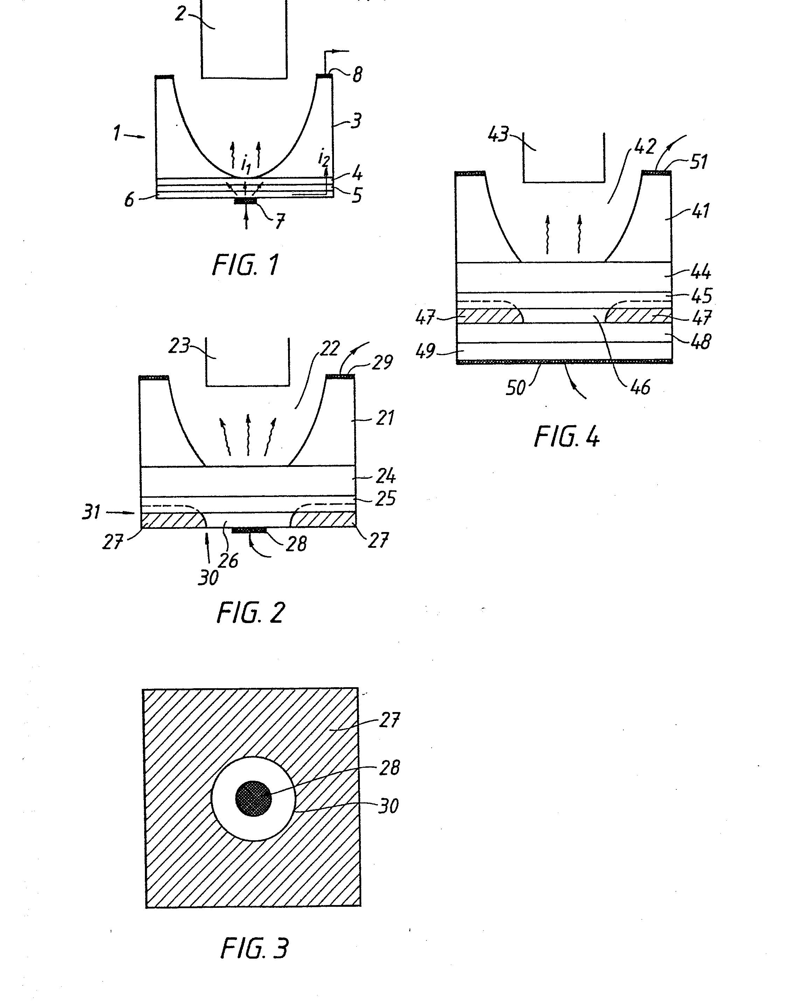

Figur 1 beschreibt ein bekanntes Halbleiterbauteil mit einer lichtemittierenden Diode 1, die optisch mit einer optischen (lichtleitenden) Faser 2 gekoppelt ist. Die Diode ist auf einem n-leitenden Substratmaterial 3 aufgebaut und umfaßt mehrere Epitaxialschichten des n-leitenden Typs 4 und des p-leitend Typs 5 und 6. Über den metallischen Kontakt 7 wird Strom durch das Bauteil zu dem metallischen Kontakt 8 geleitet. Ein Teil dieses Stromes $i_1$ passiert den pn-Übergang in dem sich unmittelbar an den metallischen Kontakt 7 anschließenden Bereich des pn-Übergangs. Dieser Teil des Stromes erzeugt mit hohem Wirkungsgrad eine Lichtstrahlung, die in die Faser 2 eingekoppelt wird. Ein anderer Teil $i_2$ des Stromes fließt dagegen in der Ebene der Schichten 5, 6 in Richtung zu den Seiten des Bauteils, um dort den pn-Übergang zu passieren. Dieser Strom trägt nicht zur einer Erzeugung einer verwertbaren Lichtstrahlung bei.

27.11.1984
21 517 PE
0151718

In den Figuren 2 und 3, die eine Ausführungsform gemäß der Erfindung zeigen, besteht das Substratmaterial 21 aus GaAs, und in dem Substratmaterial ist durch Ätzen ein Loch 22 angeordnet. 23 ist eine optische Faser, 24 eine epitaxial gezüchtete p-leitende Schicht aus $Al_xGa_{1-x}As$, 25 eine p-leitende Schicht aus GaAs und 26 eine n-leitende Schicht aus $Al_xGa_{1-x}As$. Der durch die gestrichelte Linie in Figur 2 kenntlich gemachte Bereich 27 ist in einen p-leitenden Typ umgewandelt, zum Beispiel durch Eindiffundieren von Zn-Atomen in das Material. Als Störstellenmaterial kann anstelle von Zn auch ein Material der Elementengruppe Cd, Hg, Be, Mg, Si, Ge, Sn verwendet werden. 28 und 29 sind ohmsche Kontakte. Durch die Diffusion, die den p-leitenden Bereich 27 erzeugt, wird erreicht, daß die Grenze zwischen p-dotiertem und n-dotiertem Material das Halbleiterbauteil längs der Kreislinie 30 schneidet. Man erhält somit einen pn-Übergang zwischen zwei Bereichen 26, 27 des Materials $Al_xGa_{1-x}As$ auf der Oberfläche. Ohne die genannte Diffusion würde die Grenzlinie zwischen dem pn-Übergang und der Oberfläche des Halbleiterbauteil bei 31 liegen. Im letzteren Fall würde man einen pn-Übergang zwischen GaAs und $Al_xGa_{1-x}As$ erhalten, d.h. einen heterogenen Übergang auf der Oberfläche des Bauteils. Es ist wohlbekannt, daß die Größe des Stroms, der längs der Oberfläche des Bauteils fließt, sehr stark von dem Bandabstand des Materials abhängig ist. Da $Al_xGa_{1-x}As$ mit einem wesentlich größeren Bandabstand als GaAs angeordnet werden kann, wird in dem Bauteil nach der Erfindung der Oberflächenstrom im Vergleich zu den bekannten Anordnungen erheblich reduziert. Hierdurch wird eine wesentliche Erhöhung des Wirkungsgrades bei der Lichterzeugung erzielt, und zwar besonders bei niedrigen Stromdichten.

Durch die Wahl einer ausreichend hohen Leitfähigkeit der verschiedenen Schichten des Halbleiterbauteils kann der Reihenwiderstand des Bauteils klein gehalten werden, was eine geringe Speiseleistung zur Folge hat. Dies gilt besonders für die Schichten 25 und 26. Vorzugsweise soll die Leitfähigkeit der Schicht 26 auf ihrer Oberfläche größer als 0,1 Siemens pro Meter sein, was einer Störstellenkonzentration von mehr als ca. $2 \times 10^{16}$ cm$^{-3}$ entspricht.

Figur 4 zeigt eine alternative Ausführungsform gemäß der Erfindung. 41 ist das Substratmaterial, in dem ein Loch 42 eingeätzt ist. 43 ist eine optische Faser, 44 ist eine p-leitende epitaxiale Schicht aus $Al_xGa_{1-x}As$, 45 ist eine p-leitende Schicht aus GaAs, 46 ist eine n-leitende Schicht aus $Al_xGa_{1-x}As$. Mit 47 ist ein Bereich bezeichnet, der in den p-leitenden Typ umgewandelt wurde, beispielsweise durch Diffusion von Zn-Atomen durch die Schicht 46. Die Schicht 48 ist n-leitend und besteht aus $Al_xGa_{1-x}As$. Die Schicht 49 ist n-leitend und besteht aus GaAs. Diese beiden Schichten sind epitaxial nach durchgeführter Zn-Diffusion gewachsen. Das Material der Schicht 48 hat einen größeren Bandabstand als GaAs. Dadurch, daß die Schicht 49 aus GaAs besteht, erhält man die Möglichkeit einer guten Kontaktierung der Schicht 46. Die Zn-Diffusion, die einen nicht diffundierten Bereich der Schicht 46 vollständig umschließt, durchdringt die ganze Schicht 46. Hierdurch erhält man einen pn-Übergang, dessen n-Seite aus $Al_xGa_{1-x}As$ besteht, und dessen p-Seite in dem lichtemittierenden Bereich aus GaAs und in dem Teil, der an die Oberfläche des Bauteils grenzt, aus $Al_xGa_{1-x}As$ besteht. Dieses Bauteil hat dieselben Vorteile, wie das anhand der Figuren 2 und 3 beschriebene Bauteil. Darüberhinaus hat das Halbleiterbauteil nach Figur 4 den wesentlichen Vorteil, daß sein aktiver Teil, d.h. der Bereich an dem Übergang zwischen der Schicht 45 und dem zentralen Teil der Schicht 46, von der im Sinne der Figur unteren Oberfläche des Bauteils einen größeren Abstand hat, als bei dem Bauteil nach Figur 2. Der aktive Teil wird daher weniger von in der unteren Fläche eindiffundierten Atomen, z.B. von dem Metallkontakt 50, beeinflußt, und die Lebensdauer des Bauteils wird dadurch

27.11.1984
21 517 PE
0151718

höher. Ferner wird der aktive Teil weniger von eventuellen mechanischen Spannungen in der unteren Fläche beeinfluß, und die Montage des Bauteils wird vereinfacht.

Ein lichtemittierendes Halbleiterbauteil kann im Rahmen der Erfindung, insbesondere mit Rücksicht auf sein Herstellungsverfahren, in vielfacher Weise ausgeführt sein.

27.11.1984
21 517 PE
0151718

## Patentansprüche

1. Halbleiterbauteil zur Erzeugung einer optischer Strahlung mit einem pn-Übergang zwischen einem p-leitenden Bereich und einem n-leitenden Bereich, welcher Übergang einen lichtemittierenden aktiven Teil hat, d a d u r c h  g e - k e n n z e i c h n e t, daß ein näher an einer Fläche des Bauteils angeordneter ersten Bereich (26, 27) aus einem Material mit größerem Bandabstand und ein an diesen ersten Bereich angrenzender, weiter von der Fläche entfernt liegender zweiter Bereich (25) aus einem Material mit kleinerem Bandabstand besteht, daß der zentrale Teil des pn-Übergangs zwischen diesen Bereichen der lichtemittierende Übergang des Bauteils ist, daß der erste Bereich einen zentralen Teil (26) mit einem Leitungstyp (z.B. n-leitend) hat, der dem Leitungstyp (z.B. p-leitend) des zweiten Bereichs (25) entgegengesetzt ist, und einen peripheren Teil (27) mit demselben Leitungstyp (z.B. p-leitend) hat wie der zweite Bereich (25), und daß sich der periphere Teil (27) durch den ganzen ersten Bereich erstreckt und den zentralen Teil vollständig umschließt.

2. Halbleiterbauteil nach Anspruch 1 d a d u r c h  g e - k e n n z e i c h n e t, daß der erste Bereich (26) an der genannten Fläche angeordnet ist und daß sein zentraler Teil mit einem Kontakt (28) für die Stromzufuhr zu dem Bauteil versehen ist.

3. Halbleiterbauteil nach einem der vorhergehenden Ansprüche, d a d u r c h  g e k e n n z e i c h n e t, daß der zentrale Teil des ersten Bereiches n-leitend ist.

4. Halbleiterbauteil nach einem der vorhergehenden Ansprüche, d a d u r c h  g e k e n n z e i c h n e t, daß die

27.11.1984
0151718

elektrische Leitfähigkeit des Materials an der genannten Fläche größer als 0,1 Siemens pro Meter ist.

5. Halbleiterbauteil nach einem der vorhergehenden Ansprüche, d a d u r c h   g e k e n n z e i c h n e t, daß das Halbleitermaterial $Al_xGa_{1-x}As$ oder $In_xGa_{1-x}As_yP_{1-y}$ ist.

6. Halbleiterbauteil nach einem der Ansprüche 1 oder 3 bis 5, d a d u r c h   g e k e n n z e i c h n e t, daß mindestens ein zwischen dem ersten Bereich (46, 47) und der genannten Fläche angeordneter an den ersten Bereich (46, 47) angrenzender Bereich (48) vorhanden ist, der einen größeren Bandabstand als der zweite Bereich (45) hat und vom gleichen Leitungstyp (n) wie der zentrale Teil des ersten Bereiches ist.

21 517 PE
20.12.1935

0151718

FIG. 1

FIG. 2

FIG. 3

FIG. 4